# FASCICULE DE BREVET EUROPEEN

(11) **EP 4 139 695 B1**
(45) Date de publication et mention de la délivrance du brevet: **14.02.2024**
(21) Numéro de dépôt: 21720475.9
(22) Date de dépôt: 22.04.2021
(51) Int. Cl.: G01R 3/00, G01R 15/18

(54) **PROCÉDÉ DE FABRICATION D'UN COMPOSANT ÉLECTRIQUE ET COMPOSANT ÉLECTRIQUE**
VERFAHREN ZUR HERSTELLUNG EINES ELEKTRISCHEN BAUTEILS UND ELEKTRISCHES BAUTEIL
METHOD FOR MANUFACTURING AN ELECTRIC COMPONENT AND ELECTRIC COMPONENT

(30) Priorité: 23.04.2020 FR 2004060
(43) Date de publication de la demande: 01.03.2023
(73) Titulaire: Schneider Electric Industries SAS, 92500 Rueil-Malmaison (FR)
(72) Inventeur: CHANVILLARD, Christophe, 38320 EYBENS (FR); RONDOT, Loïc, 38240 MEYLAN (FR); URANKAR, Lionel, 2000 NEUCHÂTEL (CH)
(74) Mandataire: Lavoix
(86) Numéro de dépôt international: PCT/EP2021/060520
(87) Numéro de publication internationale: WO 2021/214211

(56) Documents cités:
- EP-A1- 3 037 829
- EP-A1- 3 171 182

## Description

La présente invention concerne un procédé de fabrication d'un composant électrique et le composant électrique susceptible d'être obtenu à l'aide d'un tel procédé.

Un capteur de courant électrique est utilisé pour mesurer l'intensité d'un courant électrique circulant dans une ligne électrique. Une telle mesure peut s'avérer nécessaire pour quantifier la puissance et/ou l'énergie électrique consommée par un récepteur électrique ou pour détecter une anomalie de fonctionnement du récepteur. En tant que capteur, il est connu d'utiliser un capteur de courant de type Rogowski, qui met en oeuvre un ou plusieurs enroulements de fil conducteur autour d'un noyau amagnétique, ce type de capteur étant généralement associé à un circuit de traitement du signal incluant un circuit intégrateur.

Le capteur peut se présenter par exemple sous la forme d'un enroulement de conducteur qui s'étend le long d'une trajectoire circulaire ou rectangulaire. On obtient donc par exemple un enroulement torique, qui forme une boucle. Durant l'utilisation, la ligne électrique dont l'intensité doit être mesurée est positionnée de sorte à traverser la boucle décrite par l'enroulement, au centre de la trajectoire. La ligne électrique est donc radialement entourée par l'enroulement. Pour réduire les perturbations pour la mesure, on peut prévoir que l'enroulement comprend des spires aller qui sont entrecroisées avec des spires retour, ou que les spires retour sont bobinées à l'intérieur ou parallèlement sous des spires aller, ou encore que qu'une partie non bobinée du conducteur, émanant d'une extrémité de l'enroulement de spires aller repasse par l'intérieur de l'enroulement en sens inverse, le long de la trajectoire dudit enroulement. EP3171182A1 donne quelques exemples à ce sujet.

Pour construire ce type d'enroulement, on bobine traditionnellement un fil de cuivre, parfois autour d'un noyau en matière plastique polymère de forme torique, parfois sur une carte de circuit imprimé multicouche, comme décrit dans FR 3 075 387 A1.

Pour améliorer la compacité du capteur de courant, FR 3 053 795 A1 prévoit de former un capteur hybride, en associant des enroulements à des barreaux ferromagnétiques, disposées de façon à ménager des ouvertures destinées à être traversées par les conducteurs dont le courant doit être mesuré.

La précision de la mesure dépend notamment de la précision de la géométrie des spires et de la régularité de leur agencement spatial. Par ailleurs, un nombre de spires élevé est souhaitable pour obtenir un gain important. Il est donc nécessaire de prévoir des machines de bobinage de fil conducteur complexes et coûteuses. En outre, le bobinage de l'enroulement limite la densité de spires et le conducteur enroulé est susceptible de se déformer durant l'utilisation, par exemple sous l'effet de contraintes thermiques. Enfin, le procédé de bobinage et le type de support utilisé, notamment pour le cas de la carte de circuit imprimé, impose de fortes contraintes géométriques sur la forme de l'enroulement et du capteur.

EP 3 037 829 A1 décrit un capteur de courant avec un boitier, comprenant deux parties en matière plastique, soudées l'une à l'autre par soudure laser et à l'intérieur desquelles des éléments de mesure sont reçus. La première partie du boîtier est opaque pour absorber un faisceau laser de soudage des parties, et la deuxième partie est transparente pour laisser passer le faisceau laser.

L'invention vise donc à résoudre les inconvénients susmentionnés de l'art antérieur en proposant un nouveau procédé de fabrication, visant à obtenir un composant électrique comprenant un enroulement avec une densité de spires élevée, un agencement précis et peu variable dans le temps des spires, le procédé de fabrication autorisant une conception de l'enroulement avec toute géométrie souhaitée.

L'invention a pour objet un procédé de fabrication d'un composant électrique, constituant préférentiellement un capteur de courant. Le composant électrique comprend une armature, qui est formée par un matériau comprenant une matière plastique polymère et un additif organométallique, l'armature comprenant un bras de support qui s'étend le long d'une trajectoire directrice. Le composant électrique comprend en outre un enroulement, qui est formé directement en surface du bras de support par une piste conductrice décrivant des spires de l'enroulement, qui sont réparties le long de la trajectoire directrice et qui entourent la trajectoire directrice. Le procédé de fabrication comprenant successivement : une fourniture ou une fabrication de l'armature ; une gravure par laser du bras de support, pour graver une piste d'amorce décrivant les spires de l'enroulement et où l'additif organométallique est localement activé ; et une métallisation de la piste d'amorce avec un métal conducteur pour former la piste conductrice directement en surface du bras de support, selon les spires décrites par la piste d'amorce.

Une idée à la base de l'invention est de former l'enroulement à l'aide de la piste conductrice tracée sur le bras de support de l'armature, plutôt que sous la forme d'un fil conducteur comme prévu dans l'art antérieur. La formation de la piste d'amorce par gravure laser et activation de l'additif, puis la métallisation, permettent de former la piste conductrice avec une haute résolution et selon toute géométrie souhaitée. Par exemple, la piste conductrice peut présenter une épaisseur de moins de 15µm, en étant préférentiellement formée par un dépôt de cuivre obtenu par métallisation, avantageusement revêtu par une barrière de nickel et une finition d'or, par exemple d'environ 5µm. Il en résulte que l'on peut obtenir une densité de spires particulièrement élevée pour l'enroulement, entraînant une compacité élevée de l'enroulement et/ou un gain élevé si l'enroulement du composant est utilisé en tant que capteur. Par exemple, les spires se caractérisent par un pas inférieur à 400µm, par exemple d'environ 200µm. Le tracé de la piste conductrice est très précis puisqu'il est essentiellement déterminé par la précision de la gravure par laser et la qualité de la métallisation. Il est aisé d'obtenir toute forme souhaitée pour l'enroulement, puisque cela dépend du tracé de la gravure par laser et de la forme de la surface extérieure de l'armature, qui peut aisément être conformée par moulage lors de sa fabrication. Le bras de support de l'armature étant une pièce volumique, la surface de chaque spire peut facilement être relativement élevée, notamment par rapport à un enroulement de l'art antérieur qui serait formé autour sur une carte de circuit imprimé, par nature relativement peu épaisse et conduisant souvent à concevoir des spires de forme aplaties.

La piste conductrice étant intimement liée au bras de support de l'armature, elle conserve sa forme initiale dans le temps et est peu sensible à une déformation sous l'effet de la chaleur, contrairement aux enroulements réalisés à l'aide de fil conducteur bobiné.

Il résulte de cette grande qualité de réalisation de l'enroulement que le composant électrique obtenu par le procédé de fabrication est particulièrement adapté pour former un capteur de courant, notamment un capteur de type Rogowski, l'armature pouvant avantageusement constituer un noyau amagnétique.

D'autres caractéristiques optionnelles et avantageuses de l'invention sont décrites ci-après.

De préférence, le bras de support comprend un premier côté et un deuxième côté opposés et jointifs de part et d'autre de la trajectoire directrice, alors que la gravure par laser comprend : une gravure par laser d'une première partie de la piste d'amorce sur le premier côté, la première partie de la piste d'amorce décrivant, pour chaque spire, une première portion seulement de ladite spire, et une gravure par laser d'une deuxième partie de la piste d'amorce sur le deuxième côté, seulement après la gravure de la première partie de la piste d'amorce, la deuxième partie de la piste d'amorce décrivant, pour chaque spire, une deuxième portion de la spire complétant la première portion de ladite spire.

De préférence, la gravure par laser comprend : un positionnement l'armature pour que le premier côté soit tourné face à un graveur laser, pour que la gravure par laser de la première partie de la piste d'amorce soit effectuée par le graveur laser ; et un repositionnement l'armature pour que le deuxième côté soit tourné face au graveur laser, pour que la gravure par laser de la deuxième partie de la piste d'amorce soit effectuée par le graveur laser.

De préférence, la fabrication de l'armature comprend un moulage de l'armature par injection du matériau dans un moule.

De préférence, le moule comprend : une chambre de conformation du bras de support ; une première ouverture pour l'injection d'une première partie du matériau ; une deuxième ouverture pour l'injection d'une deuxième partie du matériau ; et une chambre de rencontre dans laquelle débouche la deuxième ouverture et qui communique avec la première ouverture par l'intermédiaire de la chambre de conformation du bras de support. De préférence, le moulage par injection comprend : une injection de la première partie du matériau dans le moule par la première ouverture, de sorte que la première partie du matériau : envahisse la chambre de conformation du bras de support, le bras de support étant alors entièrement formé par la première partie du matériau ; s'étende jusque dans la chambre de rencontre. Le moulage par injection comprend en outre une injection de la deuxième partie du matériau dans le moule par la deuxième ouverture, de sorte que la deuxième partie du matériau rencontre la première partie du matériau dans la chambre de rencontre, l'armature étant formée par combinaison de la première partie du matériau et de la deuxième partie du matériau.

De préférence, la première ouverture et la deuxième ouverture sont disposées dans un même plan et dans une même orientation, de sorte que : la première ouverture conforme un premier plot de l'armature, par l'injection de la première partie du matériau ; et la deuxième ouverture conforme un deuxième plot de l'armature, par l'injection de la deuxième partie du matériau, le premier plot et le deuxième plot étant configurés pour réaliser un positionnement du composant électrique sur une carte de circuit imprimé.

De préférence, le procédé de fabrication comprend : une fabrication ou une fourniture d'un barreau en matériau ferromagnétique, et une fixation du barreau sur un bras de fixation appartenant à l'armature, après la fourniture ou la fabrication de l'armature. De préférence, le moulage comprend la formation du bras de support et du bras de fixation dans le moule, de sorte que le bras de support et le bras de fixation sont formés d'un seul tenant.

De préférence, la fixation du barreau comprend un encliquetage du barreau sur le bras de fixation, à l'aide de moyens d'encliquetage complémentaires appartenant au barreau et au bras de fixation.

De préférence, la fixation du barreau comprend : un positionnement du barreau sur le bras de fixation, avec enfilement d'un orifice de bouterollage, traversant du barreau, sur un pion de bouterollage, appartenant au bras de fixation ; et une fixation du barreau ainsi positionné sur le bras de fixation par bouterollage, en effectuant une fusion du pion de bouterollage.

L'invention concerne également un composant électrique, susceptible d'être obtenu à l'aide du procédé de fabrication défini ci-avant, le composant électrique comprenant une armature, qui est formée par un matériau comprenant une matière plastique polymère et un additif organométallique, l'armature comprenant un bras de support qui s'étend le long d'une trajectoire directrice. Le composant électrique comprend en outre un enroulement, qui est formé directement en surface du bras de support par une piste conductrice décrivant des spires de l'enroulement, qui sont réparties le long de la trajectoire directrice et qui entourent la trajectoire directrice.

De préférence, le composant électrique selon l'invention est obtenu à l'aide du procédé de fabrication susmentionné.

En variante, on peut prévoir que le composant électrique fabriqué par le procédé décrit ci-avant constitue une antenne, plutôt qu'un capteur de courant. Pour cette variante, l'enroulement est configuré de sorte à pouvoir rayonner et/ou capter des ondes électromagnétiques. Dans ce cas, le composant électrique peut être intégré à un système radioélectrique.

L'invention sera mieux comprise à la lecture de la description ci-après d'exemples de réalisation de l'invention, donnés à titre illustratif et non limitatif, en référence aux dessins annexés listés ci-après.
[Fig 1] La figure 1 est une vue en perspective éclatée d'un composant électrique selon un premier mode de réalisation conforme à l'invention.
[Fig 2] La figure 2 est une vue en perspective, sous un autre angle, du composant électrique de la figure 1.
[Fig 3] La figure 3 montre schématiquement différentes étapes d'un procédé de fabrication du composant électrique des figures 1 et 2.
[Fig 4] La figure 4 est une vue en perspective d'un composant électrique selon un deuxième mode de réalisation conforme à l'invention.
[Fig 5] La figure 5 est une vue en perspective éclatée d'un composant électrique selon un troisième mode de réalisation conforme à l'invention.
[Fig 6] La figure 6 est une vue en perspective éclatée d'un composant électrique selon un quatrième mode de réalisation conforme à l'invention.
[Fig 7] La figure 7 est une vue en perspective d'un composant électrique selon un cinquième mode de réalisation conforme à l'invention.

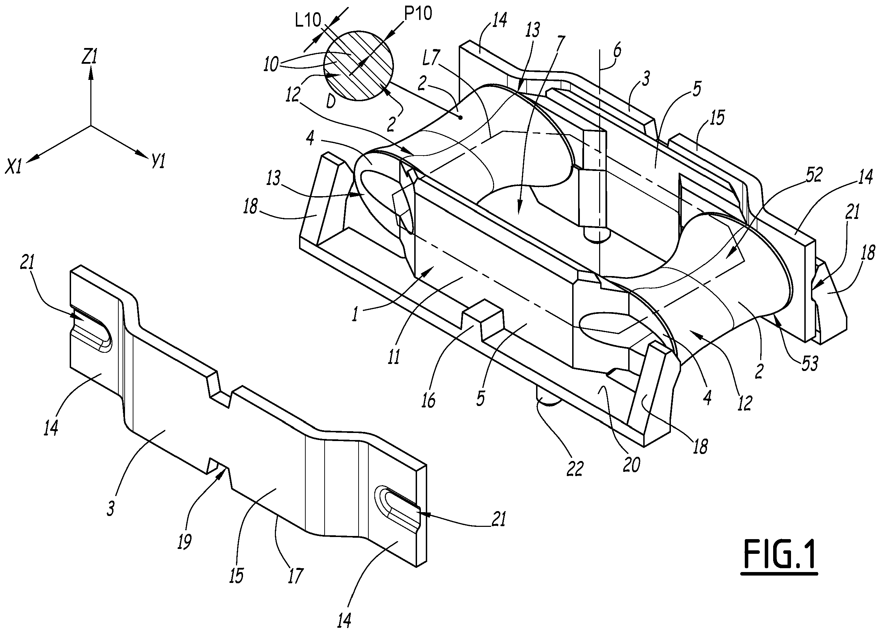

Selon le mode de réalisation des figures 1 à 3, le composant électrique comprend une armature 1, deux enroulements 2 et deux barreaux 3. On utilise un repère de référence incluant une direction longitudinale X1, une direction transversale Y1, une direction de hauteur Z1, perpendiculaires entre elles et fixes par rapport à l'armature 1.

Le composant des figures 1 à 3 constitue préférentiellement un capteur de courant. L'intensité du courant d'un conducteur 6, essentiellement parallèle à la direction Z1, traversant une trajectoire directrice L7 décrite par le composant, en forme de boucle fermée, inscrite dans un plan parallèle aux directions X1 et Y1, peut être déterminée grâce au composant, une tension étant induite aux bornes du composant en fonction du flux magnétique traversant ladite ouverture 7 selon la direction Z1. En pratique, l'armature 1 délimite une ouverture 7 du composant, dans le même plan que la trajectoire directrice L7 et étant entourée par la trajectoire directrice L7, au travers de laquelle le conducteur 6 peut être passé. De préférence, ce composant est de type capteur de Rogowski et la tension induite reflète la valeur de la variation du courant traversant l'ouverture 7.

Ce composant est préférentiellement destiné à être monté sur une carte de circuit imprimé, non représentée, par l'intermédiaire de l'armature 1, la carte de circuit imprimée s'étendant sous le composant parallèlement aux directions X1 et Y1. Ce composant est destiné à être connecté à une électronique de capteur, incluant une électronique de conditionnement se présentant par exemple sous la forme d'un circuit intégrateur.

Le composant, en particulier l'armature 1, mesure par exemple environ 25 mm selon la direction Y1 et environ 15 mm selon la direction X1. Plus généralement, le composant décrit ici présente avantageusement une longueur inférieure à 50 mm et une largeur inférieure à 40 mm.

L'armature 1 est formée, de préférence en constituant une unique pièce formée d'un seul tenant, c'est-à-dire de façon monolithique, entièrement dans un même matériau.

Le matériau comprend une matière plastique polymère, qui est de préférence une résine thermoplastique, par exemple en polycarbonate (PC), relativement facile à mouler par injection, ou en polymère à cristaux liquides (LCP), résistant particulièrement bien à la chaleur, ce qui est indiqué lorsque l'on souhaite effectuer des brasures sur la carte de circuit imprimé. Le matériau comprend aussi un additif organométallique, intégré à la matière plastique polymère, qui est réparti au moins en peau de l'armature, voire également à coeur. L'additif organométallique, dans un état non-activé, est électriquement non-conducteur. L'armature 1 est donc électriquement non-conductrice et amagnétique, sauf éventuellement pour toute partie activée de l'additif organométallique, comme discuté ci-après.

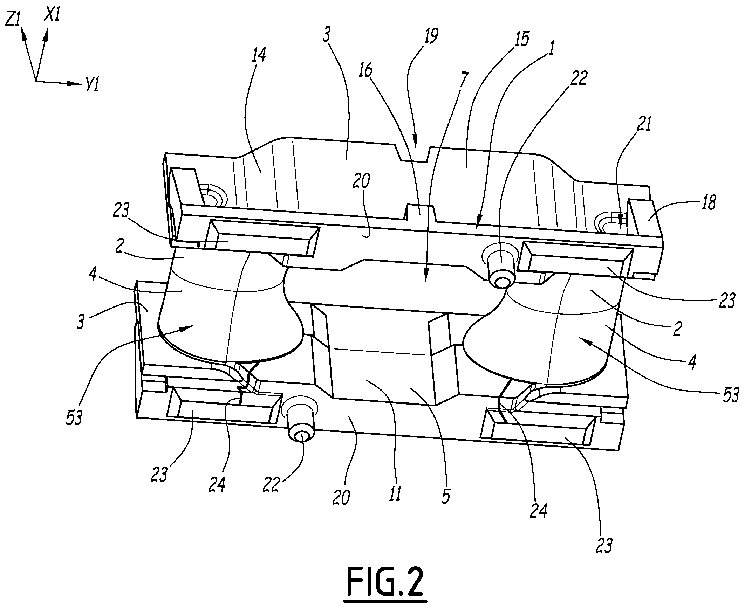

Comme montré sur les figures 1 et 2, structurellement, l'armature 1 s'étend le long de la trajectoire directrice L7 et présente avantageusement une forme générale de boucle fermée, ou plus généralement une forme annulaire, délimitant en son centre l'ouverture 7, qui est traversante. L'armature 1 comprend deux bras de support 4 et deux bras de fixation 5. Dans le présent exemple, les deux bras de support 4 sont disposés en face l'un de l'autre, de part et d'autre de l'ouverture 7, pour la délimiter. Chaque bras de support 4 s'étend ici parallèlement à la direction X1. Les deux bras de fixation 5 sont disposés en face l'un de l'autre de l'ouverture 7, pour la délimiter. Chaque bras de fixation 5 s'étend parallèlement à la direction Y1. Chaque bras de fixation 5 s'étend ici parallèlement à la direction Y1. Chaque bras de fixation 5 relie, par ses extrémités, une extrémité d'un bras 4 à une autre extrémité de bras 4. En d'autres termes, le long de la trajectoire L7, autour du conducteur 6, on a une alternance de bras 4 et de bras 5. Pour l'exemple des figures 1 et 2, chaque bras 4 et 5 est de forme rectiligne, ou en forme courbe, pour tourner autour du conducteur 6.

Chaque bras de support 4 est prévu pour recevoir l'un des enroulements 2 alors que chaque bras de fixation 5 est prévu pour recevoir l'un des barreaux 3. Sur la figure 1, l'un des barreaux 3 est représenté démonté de l'armature 1, alors que l'autre est représenté monté.

Chaque enroulement 2 est formé directement en surface du bras de support 4 concerné.

En particulier, le long de la trajectoire L7, chaque bras de support 4 présente une surface externe radiale 12, c'est-à-dire une surface en forme de manche autour de la trajectoire L7. A chaque extrémité axiale de cette surface radiale 12, c'est-à-dire à chaque extrémité axiale du bras 4, le bras 4 comprend une surface axiale 13 respective, c'est-à-dire une surface d'extrémité. Ici, l'enroulement 2 est formé exclusivement sur la surface radiale 12, alors que les deux surfaces axiales 13 sont dépourvues d'enroulement.

Chaque enroulement 2 est constitué par une piste conductrice 10 respective, c'est-à-dire électriquement conductrice au regard du matériau constituant l'armature 1, lequel est électriquement isolant. Le composant montré aux figures 1 et 2 comporte donc deux pistes 10 distinctes, formant chacune un enroulement 2 séparé. Chaque piste conductrice 10 est formée en surface du bras de support 4 qui la porte, ici en la surface radiale 12. Chaque piste conductrice 10 étant très fine, une partie de l'une d'elle est illustrée sur une vue de détail D de la figure 1, à plus grande échelle.

Comportant une ou plusieurs pistes conductrices 10 formée sur l'armature 1 en matière plastique polymère, le composant électrique peut être qualifié de composant plastronique, ou de capteur plastronique.

Structurellement, la piste conductrice 10 forme un fil plat continu, préférentiellement sans ramification, agencé à plat en surface extérieure du bras 4. La piste conductrice 10 s'enroule en spirale autour du bras 4, afin de former une succession de spires constituant l'enroulement 2. Les spires sont réparties successivement le long de la trajectoire L7, préférentiellement de façon régulière. Chaque spire entoure une portion de la trajectoire L7. En d'autres termes, ici, les spires sont réparties parallèlement à la direction X1, alors que chaque spire est préférentiellement approximativement inscrite dans un plan parallèle aux directions Y1 et Z1. La piste 10 étant formée directement en surface du bras 4, c'est la forme de la surface radiale 12 qui détermine la géométrie de la section transversale de chaque spire et donc l'enveloppe de l'enroulement 2. En particulier, pour chaque spire, la section transversale de la spire correspond au contour extérieur de la section transversale du bras 4. Ici, chaque bras 4 présente avantageusement une forme tubulaire, ou plus généralement volumique, qui entoure la trajectoire L7. Il en résulte que l'enroulement 2 est lui-même volumique selon les directions Y1 et Z1, et peut facilement avoir des spires dont la section couvre une aire importante et présente toute forme souhaitée. On peut avantageusement former des spires à section circulaire ou elliptique, comme c'est le cas dans l'exemple illustré. Alternativement, on pourrait prévoir que les spires sont à section carrée ou rectangulaire, ou de toute autre forme de section souhaitée, en modifiant la forme du bras 4, en particulier de sa surface radiale 12.

Grâce au procédé de fabrication décrit ci-après, la piste 10 présente une largeur de piste L10 qui peut être avantageusement inférieure à 400µm (micromètres), voire inférieure à 200 µm. Le pas P10 de l'enroulement 2, c'est-à-dire la distance reliant une spire à l'autre, est avantageusement inférieur à 400µm, voire inférieure à 200 µm. On peut donc obtenir une densité de spires très élevée le long de la trajectoire L7, par exemple de plusieurs spires par millimètre, ainsi qu'un tracé très précis de piste conductrice 10. En comparaison, la section de l'enroulement 2 peut être rendue très grande en prévoyant que le bras de support 4 présente toute forme souhaitée. En particulier, la section de l'enroulement 2 peut présenter un diamètre, ou sinon une grandeur caractéristique telle qu'une diagonale, qui est supérieur à 3 mm (millimètres), par exemple 5 mm, voire supérieur à 5 mm. Par exemple, chaque spire peut présenter une circonférence d'environ 20 mm. La longueur de chaque enroulement 2, mesurée le long de la trajectoire L7, peut par exemple être comprise entre 5 et 15 mm.

De préférence, le bras de support 4 forme un noyau amagnétique pour l'enroulement 2. Si le bras de support 4 est de forme tubulaire, comme c'est le cas sur les figures 1 et 2, la quantité d'air contenue dans le tube a également une fonction de noyau amagnétique.

De préférence, pour former un circuit magnétique le long de la trajectoire directrice L7, les deux enroulements 2 ont leurs spires orientées dans le même sens, par exemple le sens direct, c'est-à-dire le sens de vissage, le long et autour de la trajectoire L7. Par exemple, il en résulte que l'un des enroulements 2 a ses spires orientées dans le sens direct par rapport à la direction X1, et que l'autre enroulement 2, opposé, a ses spires orientées dans le sens direct par rapport à une direction opposée à la direction X1.

Chaque barreau 3 est constitué de matériau ferromagnétique, par exemple un fer doux. Chaque barreau 3 constitue une pièce qui est rapportée sur l'armature 1, contrairement aux enroulement 2 qui y sont intégrés.

Chaque barreau 3 se présente avantageusement sous la forme d'une lame, qui s'étend parallèlement à la direction Y1. Le barreau 3 comporte deux extrémités axiales 14 et une partie centrale 15 reliant les deux extrémités axiales 14 entre elles. A chacune de ses extrémités 14, le barreau 3 est en contact mécanique avec l'une des surfaces axiale 13 de l'un des bras 4, parallèlement à la direction X1, c'est-à-dire, localement, perpendiculairement à la trajectoire L7. Chaque barreau 3 relie donc une extrémité axiale du premier enroulement 2 avec l'extrémité de l'autre enroulement, sans contact électrique avec les pistes 10 constituant respectivement ces enroulements 2, mais le plus proche possible pour réduire l'entrefer. On obtient donc un circuit magnétique en forme de boucle le long de la trajectoire L7, formé par une alternance des enroulements 2 et des barreaux 3. En fonctionnement, des lignes de champ magnétique s'étendent le long de la trajectoire L7.

Chaque bras de fixation 5 sert à la fois à supporter les bras de support 4, mais aussi à supporter l'un des barreaux 3.

Pour soutenir fixement les bras de support 4 l'un par rapport à l'autre, chaque bras de fixation 5 comprend un arceau 11, qui relie structurellement l'extrémité de l'un des bras 4 à l'extrémité de l'autre bras 4. Avec les bras 4, les arceaux 11 délimitent l'ouverture 7 du composant électrique. Chaque arceau 11 s'étend avantageusement parallèlement aux directions Y1 et Z1. Chaque arceau 11 est mécaniquement rattachée aux deux bras de support 4. Pour chaque bras 4, l'arceau 11 est rattaché à l'extrémité axiale du bras 4, ou plus généralement sur une zone du bras 4 ne comportant pas l'enroulement 2. De préférence, comme montré aux figures 1 et 2, l'encombrement de l'extrémité axiale du bras 4 par l'arceau 11 est le plus faible possible, pour que la surface axiale 13, réservée au contact avec le barreau 3, soit la plus grande possible.

Chaque bras de fixation 5 comprend avantageusement une base 20, qui s'étend parallèlement aux directions X1 et Y1, de sorte que les bases 20 des deux bras appartiennent à un même plan. Chaque base 20 est rattaché à l'arceau 11 par un bord longitudinal dudit arceau 11, s'étendant parallèlement à la direction Y1. Alors que les arceaux 11 et les bras 4 sont disposés tous dans un même plan incluant la trajectoire L7, les bases 20 sont disposées dans un plan parallèle, décalé par rapport au plan de la trajectoire L7.

Pour positionner le barreau 3 sur l'armature 1 selon la direction X1, on prévoit avantageusement que les extrémités 14 sont en appui contre les surfaces 13 des bras de support 4 et/ou que la partie centrale 15 du barreau 3 est en appui contre les arceaux 11. Le barreau 3 se trouve séparé de l'ouverture 7 par l'arceau 11.

Pour positionner le barreau 3 sur l'armature 1 selon la direction Z1, on prévoit avantageusement qu'un bord longitudinal 17 du barreau 3 vient en appui contre la base 20 du bras 5 sur lequel ce barreau 3 est reçu.

Pour positionner le barreau 3 sur l'armature 1 selon la direction Y1, le bras de fixation 5 et le barreau 3 forment avantageusement une butée incluant un pion 16, formé ici par l'arceau 11 à l'intersection entre la base 20 et l'arceau 11, à l'extérieur de l'ouverture 7, et une encoche 19, formée ici par le bord longitudinal 17 du barreau 3. Le positionnement du barreau est assuré par réception du pion 16 dans l'encoche 19.

De façon optionnelle, le positionnement du barreau 3 parallèlement à la direction Y1 est au moins en partie assuré par une correspondance de forme entre le barreau 3 et l'arceau 11 du bras 5. Comme illustré aux figures 1 et 2, le barreau 3 présente avantageusement une forme arquée, où la partie centrale 15 s'étend dans un premier plan, qui est parallèle aux directions Y1 et Z1, et où les extrémités 14 s'étendent toutes deux dans un même deuxième plan qui est parallèle aux directions Y1 et Z1, le plan des extrémités 14 et étant décalé par rapport au plan de la partie centrale. L'arceau 11 épouse cette forme particulière pour positionner le barreau 3 parallèlement à la direction Y1.

Pour fixer le barreau 3 sur l'armature 1, le bras 5 concerné comprend des pattes d'encliquetage 18, par exemple deux pattes 18. Ici, les pattes d'encliquetage 18 coopèrent respectivement avec l'une des extrémités 14 du barreau 3. Pour cela, les pattes 18 sont ici portées à des extrémités longitudinales de la base 20 et s'étendant chacun dans la direction Z1, de façon à se trouver chacun en regard de l'une des surfaces 13. Le pion 16 est donc agencé entre les deux pattes 18. Chaque extrémité 14 comporte avantageusement un renfoncement 21 pour recevoir une excroissance formant un crochet, portée par l'extrémité de la patte 18. Une fois encliqueté, le barreau 3 est capturé parallèlement à la direction Z1 entre la base 20 et le crochet de la patte 18, reçue dans le renfoncement 21. Les pattes 18 et les renfoncements 21 constituent un exemple de moyens d'encliquetage complémentaires formés par le barreau 3 et le bras 5.

La fixation du barreau 3 sur l'armature est donc particulièrement aisée, puisqu'il suffit d'enfiler le barreau 3 sur le bras 5 en déplaçant le barreau 3 dans une direction opposée à la direction Z1 par rapport à l'armature 1, jusqu'à réception du pion 16 par l'encoche 19 et encliquetage des pattes 18 dans les renfoncements 21.

L'agencement des moyens de positionnement et de fixation des barreaux 3 de l'exemple des figures 1 et 2 permet avantageusement d'avoir des bras présentant plusieurs symétries, qui les rendent interchangeables si besoin, ce qui facilite notamment la fabrication du composant électrique. Par exemple, le barreau 3 est symétrique par rapport à un plan parallèle aux directions X1 et Y1, de sorte que chaque barreau 3 comporte deux bords longitudinaux 17 symétriques, portant chacun une encoche 19 symétrique. Par exemple, le barreau 3 est symétrique par rapport à un plan parallèle aux directions X1 et Z1, de sorte que les extrémités 14 sont interchangeables.

De préférence, l'armature 1 comprend en outre des pieds 23, mieux visibles sur la figure 2. Quatre pieds 23 sont préférentiellement prévus. Ici, chaque pied 23 est formé en saillie de l'un des bras de fixation 5, en particulier de la base 20, en étant tournés dans une direction opposée à la direction Z1. Chaque pied 23 est avantageusement monolithique avec le bras 5 qui le supporte. Chaque bras 5 comporte par exemple deux pieds 23 à ses extrémités longitudinales. On prévoit avantageusement que, pour un même bras 5, les pieds sont répartis parallèlement à la direction Y1. Pour deux bras 5 opposés, on prévoit avantageusement que les pieds sont répartis par paire, chaque paire de pieds 23 étant parallèle à la direction X1. De préférence, chaque paire de pied 23 est alignée avec l'un des enroulements 2.

Le composant électrique est avantageusement prévu pour être disposé sur la carte de circuit imprimé par l'intermédiaire des bras de fixation 5, en particulier par l'intermédiaire des bases 20, ici plus précisément en reposant sur les quatre pieds 23.

De préférence, chaque enroulement 2 est électriquement connecté au circuit électrique de la carte de circuit imprimé par l'intermédiaire de deux pieds 23. Plus précisément, chaque enroulement 2 présente deux extrémités, constituant les deux bornes de l'enroulement 2 concerné. Pour chaque extrémité de l'enroulement 2, une piste conductrice auxiliaire 24 respective relie avantageusement l'extrémité de l'enroulement 2 au pied 23. De préférence, cette piste 24 est de même nature que la piste conductrice 10 de l'enroulement 2 et obtenue par le même procédé et fabriquée en même temps, en surface de l'armature 1. Electriquement, les deux enroulements sont avantageusement connectés en série entre eux et avec un circuit pour traiter le signal qui en émane. Ces connexions sont préférentiellement effectuées par l'intermédiaire de la carte de circuit électronique. On peut avantageusement prévoir que les connexions des enroulements 2 et les pistes de retour éventuelles sont formées directement sur la carte de circuit électronique. En particulier, pour chaque enroulement 2, on prévoit une piste de retour respective, qui s'étend sous l'enroulement 2 concerné, en suivant la trajectoire directrice L7 dans le plan de la carte de circuit imprimé. Ici, au moins une portion de chaque piste de retour est rectiligne et parallèle à la direction X1, en s'étendant sous l'enroulement 2 concerné, d'une extrémité axiale à l'autre de cet enroulement 2. En série, se succèdent donc le premier enroulement 2, la première piste de retour, la deuxième piste de retour et le deuxième enroulement 2.

De préférence, l'armature 1 comprend en outre des plots 22, mieux visibles sur la figure 2. Ici, chaque plot 22 est en saillie de l'un des bras de fixation 5 de façon monolithique, en particulier en étant saillant de la base 20 à l'opposé de l'arceau 11. Chaque plot 22 est saillant dans une direction opposée à la direction Z1. Chaque plot 22 permet avantageusement de positionner et/ou de fixer le composant électrique, notamment selon les directions X1 et Y1, sur la carte de circuit imprimé, laquelle comporte par exemple des orifices correspondants pour recevoir les plots 22. Pour cela, les plots 22 sont avantageusement disposés dans un même plan parallèle aux directions X1 et Y1 et sont orientés dans une même direction, ici la direction opposée à la direction Z1.

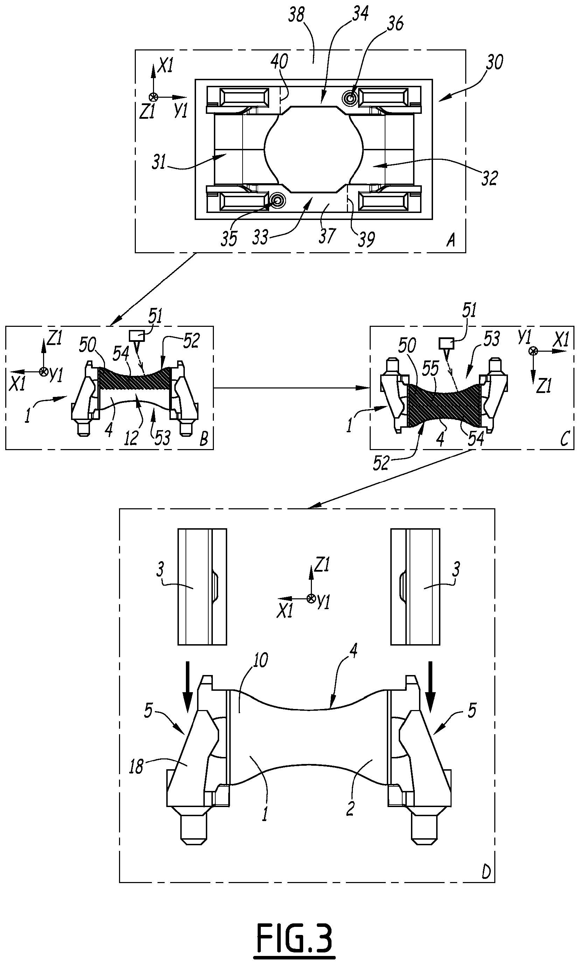

Le composant électrique des figures 1 et 2 est obtenu à l'aide du procédé de fabrication défini ci-dessous et illustré sur la figure 3.

Pour l'essentiel, le procédé de fabrication comprend successivement une fourniture ou une fabrication de l'armature 1 illustrée sur une vignette A de la figure 3, puis une gravure par laser de l'armature 1 illustrée sur les vignettes B et C de la figure 3, puis un traitement chimique de l'armature 1 incluant une métallisation, non représentée, puis un assemblage des barreaux 3 sur l'armature 1 montrée sur la vignette D de la figure 3.

La fabrication de l'armature 1 comprend préférentiellement un moulage de l'armature 1 par injection du matériau dans un moule, alors que le matériau est dans un état visqueux. L'une des empreintes 30 du moule est montrée schématiquement sur la vignette A de la figure 3, sachant que le moule comprend avantageusement une autre empreinte, et préférentiellement des noyaux, en particulier pour obtenir la forme tubulaire des bras de support 4. Le moule est configuré pour conformer, en une seule opération de moulage, toutes les parties de l'armature 1, c'est-à-dire notamment les bras 4 et 5, les pieds 23 et les plots 22.

Comme montré sur la figure 3 pour l'empreinte 30, le moule comprend préférentiellement des chambres 31, 32, 33 et 34, les chambres 31 et 32 étant conçues pour conformer chacune l'un des bras de support 4, les chambres 33 et 34 étant chacune conçues pour conformer l'un des bras de fixation 5. Tout comme l'armature 1, le moule présente une forme annulaire autour d'un axe parallèle à la direction Z1. Ainsi, la chambre 31 relie les chambres 33 et 34, la chambre 32 relie les chambres 33 et 34, la chambre 33 relie les chambres 31 et 32, la chambre 34 relie les chambres 31 et 32.

Dans le présent exemple, les empreintes du moule, dont l'empreinte 30, sont refermées parallèlement à la direction Z1. Ainsi, l'empreinte 30 forme le dessous de l'armature 1, incluant ici les plots 22, les pieds 23 et les bases 20, alors que l'autre empreinte, non représentée, forme le dessus de l'armature 1.

Le moule comprend aussi deux ouvertures 35 et 36 pour l'injection du matériau dans le moule, qui sont ici toutes deux ménagées dans l'empreinte 30. Dans le présent exemple, l'ouverture 35 débouche directement dans la chambre 33 et l'ouverture 36 débouche directement dans la chambre 34. Plus généralement, on préfère que chaque ouverture du moule débouche dans une chambre formant l'un des bras de fixation 5, ou pour le moins dans une chambre qui ne forme pas l'un des bras de support 4, dont la surface radiale 12 doit présenter un état irréprochable et dont la structure doit résister à la gravure laser. De manière avantageuse, les ouvertures 35 et 36 conforment les plots 22 de l'armature 1. En effet, les plots 22 constituent une partie de l'armature 1 nécessitant une précision de réalisation et des caractéristiques mécaniques de moindre qualité, notamment au regard des bras de support 4.

Pour que les plots 22 ainsi obtenus puissent servir de moyen de positionnement du composant sur la carte de circuit imprimé, on prévoit avantageusement que les ouvertures 35 et 36 sont disposées dans un même plan parallèle aux directions X1 et Y1 et dans la même orientation, ici parallèle à la direction Z1, tout en étant portées par la même empreinte 30.

De l'agencement annulaire des chambres 31 à 34, il résulte que la chambre 33 communique avec l'ouverture 36, dans une première direction, seulement par l'intermédiaire de la chambre 31 et de la chambre 34. Dans une deuxième direction, la chambre 33 communique avec l'ouverture 36 seulement par l'intermédiaire de la chambre 32 et de la chambre 34. L'ouverture 35 débouche quant à elle directement dans la chambre 33. De même, la chambre 34 communique avec l'ouverture 35, dans une première direction, seulement par l'intermédiaire de la chambre 32 et de la chambre 33. Dans une deuxième direction, la chambre 34 communique avec l'ouverture 35 seulement par l'intermédiaire de la chambre 31 et de la chambre 33. L'ouverture 36 débouche quant à elle directement dans la chambre 34.

Pour le moulage, du fait de la forme annulaire du moule, on prévoit d'injecter le matériau à la fois par les deux ouvertures 35 et 36, qui se trouvent à l'opposé l'une de l'autre, pour permettre une répartition correcte du matériau dans le moule. Une première partie 37 du matériau est injectée par l'ouverture 35, et une deuxième partie 38 du matériau est injectée par l'ouverture 36, simultanément à l'injection de la première partie 37.

Comme schématisé sur la vignette A de la figure 3, l'injection de la partie 37 du matériau conduit à une invasion partielle de la chambre 33 par cette partie 37, à une invasion complète de la chambre 31 par cette partie 37 et par une invasion partielle de la chambre 34 par cette partie 37. L'un des deux bras de support 4 est entièrement formé par la partie 37 du matériau dans la chambre 31. L'injection de la partie 38 du matériau conduit à une invasion partielle de la chambre 34 par cette partie 38, à une invasion complète de la chambre 32 par cette partie 38 et par une invasion partielle de la chambre 33 par cette partie 38. L'autre bras de support 4 est entièrement formé par la partie 38 du matériau dans la chambre 32. L'un des plots 22 est conformé par l'ouverture 35 en étant entièrement formé par la partie 37 du matériau. L'autre plot 22 est conformé par l'ouverture 36 en étant entièrement formé par la partie 38 du matériau.

Chaque partie 37 et 38 du matériau s'étend jusque dans les chambres 33 et 34, où les parties 37 et 38 se rencontrent. Chaque chambre 33 et 34 sert donc de chambre de rencontre entre les parties 37 et 38 du matériau. Dans la chambre 33, la rencontre entre les parties 37 et 38 du matériau se fait au niveau d'un plan de soudure 39. Dans la chambre 34, la rencontre entre les parties 37 et 38 du matériau se fait au niveau d'un plan de soudure 40. Chaque bras 5 est donc formé par la combinaison des deux parties 37 et 38 du matériau injecté. L'armature 1, en particulier, les bras 4 et 5, est formée d'un seul tenant avec le même matériau injecté en une seule fois dans le même moule, quoiqu'en deux parties 37 et 38.

Plus généralement, le moule est avantageusement configuré pour que les plans de soudure 39 et/ou 40 éventuels se forment hors des chambres 31 et 32, par exemple dans les chambres 33 et/ou 34. Dans l'armature 1 finie, les plans de soudure éventuels sont ainsi situés hors des bras de support 4, ce qui leur confère toute la résistance et la précision de réalisation nécessaires aux opérations subséquentes visant à former les pistes 10. Dans le présent exemple, les plans de joints éventuels sont formés au niveau des bras de fixation 5, dont les qualités sont moins critiques que celles des bras de support 4.

Une fois l'armature 1 fabriquée comme décrit ci-avant, on procède à la gravure par laser de l'armature 1, comme illustré sur les vignettes B et C de la figure 3. En particulier, pour chaque bras de support 4, on effectue une gravure par laser d'une piste d'amorce respective, qui servira plus tard de base pour la formation de la piste conductrice 10 de ce bras de support 4. Si l'on souhaite réaliser les pistes conductrices auxiliaires 24 susmentionnées, on forme aussi des pistes d'amorce auxiliaires correspondantes à cette étape, selon le même procédé que pour les pistes d'amorce visant à former les pistes conductrices 10.

Le matériau de l'armature 1 est spécialement prévu pour permettre la formation de la piste d'amorce 50 par gravure laser, par exemple à l'aide de tout graveur laser 51 approprié. Par « graveur laser », on entend par exemple un appareil comprenant à la fois une source d'un faisceau laser, des moyens pour orienter le faisceau laser, par exemple un jeu de miroirs orientables, et des moyens pour focaliser le faisceau laser, tel qu'un jeu de lentilles.

L'application du laser localement sur la surface du matériau conduit à la formation de la piste d'amorce 50, qui peut être dessinée, avec tout tracé souhaité, par application du laser. La piste d'amorce 50 se distingue du reste de la surface de l'armature 1 en ce qu'elle est constituée par des parties activées de l'additif organométallique, alors que l'additif organométallique est dans un état non activé pour le reste de l'armature 1. De plus, la piste d'amorce se distingue du reste de la surface de l'armature 1 en ce qu'elle forme un sillon, ou pour le moins en ce qu'elle présente un état de surface plus abrasif.

De préférence, l'additif organométallique est formé par un complexe métallique comprenant un noyau métallique, par exemple un noyau de cuivre, qui, dans l'état non-activé, est lié par liaison covalente à la matière plastique polymère. Cet additif organométallique est apte à être activé sélectivement, en surface de l'armature, par application locale et sélective d'un rayonnement laser approprié, par exemple un rayonnement laser infrarouge pulsé. Pour activer l'additif organométallique, le rayonnement laser brise le complexe, ce qui libère le noyau métallique seulement à l'endroit où le rayonnement est appliqué. Plus précisément, le laser entraîne une réduction du métal du complexe, le noyau se présentant alors sous forme métallique, ici du cuivre métallique. En outre, le rayonnement laser chauffe localement la surface du matériau entraîne une augmentation locale de la rugosité de la surface, par ablation partielle de la matière plastique polymère.

Pour chaque bras 4, la gravure laser vise à former la piste d'amorce 50 sur le bras 4 de sorte que la piste d'amorce 50 a exactement le même tracé que la piste conductrice 10 que l'on souhaite former. Dès lors, pour chaque bras 4, la piste d'amorce 50 est agencée en surface extérieure du bras 4, en particulier seulement sur la surface radiale 12. La piste d'amorce 50 s'enroule en spirale autour du bras 4, afin de former une succession de spires qui constitueront l'enroulement 2 à une étape ultérieure du procédé.

Pour effectuer cette gravure laser, on procède préférentiellement en deux sous étapes successives illustrées respectivement aux vignettes B et C.

Chaque bras de support 4 se divise en un côté 52 et un côté 53 opposés et jointifs de part et d'autre de la trajectoire directrice L7. Le côté 52 forme une portion, par exemple la moitié, de la surface 12, alors que l'autre côté 53 forme l'autre portion de la surface 12. La combinaison des deux côtés 52 et 53 constitue la totalité de la surface 12. Les côtés sont par exemple séparés par un plan médian du bras 4, orienté parallèlement aux directions X1 et Y1.

Dans un premier temps, comme montré sur la vignette B, on positionne l'armature 1 de sorte que le côté 52 soit tourné face au graveur laser 51. En d'autres termes, on dispose l'armature 1 de sorte que le côté 52 puisse être gravé par le graveur laser 51. Dans cette orientation, on effectue une gravure par laser d'une première partie 54 de la piste d'amorce 50 seulement sur le premier côté 52. La partie 54 ainsi gravée débute la formation de toutes les spires de la piste d'amorce 50, en formant seulement, pour chaque spire, une première portion de ladite spire, alors que la deuxième portion de la spire reste à graver. Sur la vignette B, on grave des demi-spires sur le côté 52 du bras 4. Une fois le côté 52 gravé, on repositionne l'armature 1 pour que le côté 53 soit tourné face au graveur laser 51. Une deuxième partie 55 de la piste d'amorce 50 peut alors être gravée sur le côté 53, pour compléter la première partie 54, comme montré sur la vignette C. La deuxième partie 55, occupant le côté 53, consiste, pour chaque spire, à former la portion complémentaire à celle qui est formée par la première partie 54. La combinaison des deux parties 54 et 55 forme ainsi la totalité de la piste d'amorce 50.

Les pistes d'amorce auxiliaires sont également formées lors de l'une de ces étapes, par exemple alors que l'armature est dans la position de la vignette C.

Pour passer du côté 52 au côté 53, on préfère que l'armature 1 soit retournée, par exemple par une personne ou un bras robotisé, alors que le graveur laser 51 n'est pas changé de position, hormis une simple orientation du faisceau laser pour dessiner la piste d'amorce 50.

De préférence, une fois la gravure par laser effectuée, on effectue un nettoyage de l'armature 1 pour retirer tout débris causé par cette opération.

Les pistes d'amorce 50 ainsi gravée, ainsi que tout piste d'amorce auxiliaire éventuelle, ne sont pas suffisamment conductrices d'électricité pour que le composant électrique puisse fonctionner. On procède donc au traitement chimique de l'armature 1 pour faire croître ces pistes conductrices.

Le traitement chimique consiste en premier lieu en une métallisation des pistes d'amorce 50, pour former les pistes conductrices 10 et toute piste conductrice auxiliaire 24, directement en surface de l'armature 1. La métallisation entraîne une croissance des pistes d'amorce, alors que le reste de la surface de l'armature 1 reste électriquement isolante.

Par « métallisation », on entend par exemple une métallisation autocatalytique. On plonge l'armature portant les pistes d'amorce dans une solution comprenant des ions métalliques du métal avec lequel on souhaite former les pistes conductrices, par exemple du cuivre. Par exemple, la solution comprend un sel métallique contenant les ions métalliques, ici les ions cuivre, un agent réducteur pour la réduction des ions métalliques. Par réaction d'oxydo-réduction, le métal des ions métalliques se déposent seulement sur les pistes d'amorce sans se déposer sur le reste de la surface de l'armature 1, les pistes d'amorce constituant un catalyseur de la réaction d'oxydo-réduction. La couche de métal déposée par ce procédé constitue un catalyseur pour le dépôt de davantage de métal par oxydo-réduction. C'est ainsi que croissent les pistes conductrices par la métallisation. Mécaniquement, les pistes conductrices ainsi formées sont fortement solidaire du matériau plastique polymère en s'ancrant mécaniquement aux aspérités constituées par le caractère abrasif de la surface de l'armature 1, du fait de la gravure par laser.

De préférence, une fois les pistes conductrices formées par la métallisation, les traitements chimiques incluent le dépôt de couches de finition pour protéger les pistes conductrices. A cette fin, par exemple, on met en oeuvre un procédé de type ENIG (en anglais « Electroless Nickel Immersion Gold »). Pour cela, on applique d'abord une couche de nickel-phosphore par métallisation autocatalytique sur la face libre des pistes conductrices, c'est-à-dire la face opposée à la surface de l'armature 1. Cette métallisation autocatalytique est avantageusement effectuée après que les pistes conductrices en cuivre aient été activées au palladium. Ensuite, on applique une couche d'or externe, par exemple par déplacement chimique. La couche d'or empêche l'oxydation des pistes conductrices recouvertes, alors que la couche de nickel-phosphate empêche la migration de l'or vers le cuivre.

A l'issue des traitements chimiques pour former les pistes conductrices, on fixe les barreaux 3 sur l'armature 1, à savoir sur les bras de fixation 5, comme illustré sur la vignette D de la figure 3. La fixation des barreaux est ici effectuée par encliquetage à l'aide des pattes d'encliquetage 18, une fois que l'armature 1 a été moulée et revêtue des pistes conductrices. Dans le présent exemple, pour effectuer cette fixation, on enfile le barreau 3 sur le bras 5 en déplaçant le barreau 3 dans une direction opposée à la direction Z1 par rapport à l'armature 1, jusqu'à réception du pion 16 par l'encoche 19 et encliquetage des pattes 18 dans les renfoncements 21.

Le composant est alors avantageusement terminé.

En variante, on pourrait avoir un seul bras de support 4 portant un enroulement 2, sans bras de fixation 5 et donc sans barreau, le bras de support 4 et son enroulement 2 s'étendant sur tout ou l'essentiel de la trajectoire directrice L7. Dans ce cas, l'unique bras de support 4 et son enroulement sont en forme de boucle, ou pour le moins en forme de « C ». En variante, on pourrait avoir un seul bras de support 4 portant un seul enroulement 2 et un seul bras de fixation 5 portant un seul barreau 3, le bras de fixation 5 reliant entre elles les extrémités du bras de support 4. En variante, on peut prévoir plus de deux bras de support 4, portant autant d'enroulements 2, et éventuellement plus de deux bras de fixation 5, portant autant de barreaux 3. On prévoit avantageusement que, le long de la trajectoire directrice L7, deux bras de support 4 successifs, portant chacun un enroulement 2 respectif, sont séparés par un bras de fixation 5 portant un barreau 3. Toutefois, on peut prévoir deux bras de support 4 immédiatement successifs, portant chacun un enroulement 2 respectif.

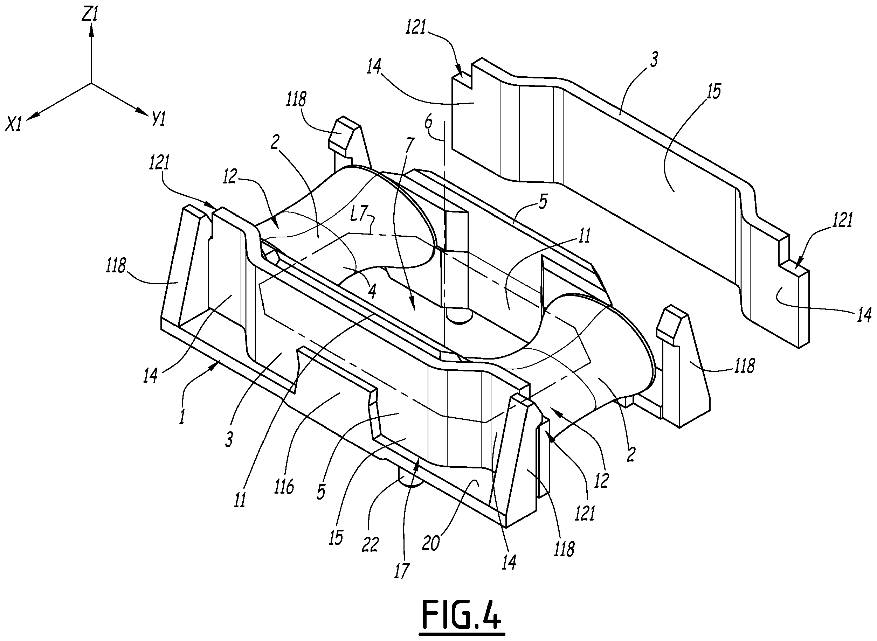

Le composant électrique du mode de réalisation illustré sur la figure 4, ainsi que son procédé de fabrication, sont identiques à ceux du mode de réalisation des figures 1 à 3, hormis pour les différences mentionnées ci-dessous. En particulier, le composant électrique de la figure 4 comprend une armature 1, deux enroulements 2, portés respectivement par deux bras de support 4 de l'armature 1, et deux barreaux 3, portés par deux bras de fixation de l'armature 1. Les mêmes signes de référence sont utilisés pour des éléments semblables entre le mode de réalisation des figures 1 à 3 et le mode de réalisation de la figure 4.

A la différence du mode de réalisation des figures 1 à 3, le mode de réalisation de la figure 4 prévoit que chaque bras 5 comprend des pattes d'encliquetage 118, au lieu des pattes 18, qui ont une double-fonction, en ce qu'elles assurent à la fois l'encliquetage et le positionnement du barreau 3 concerné parallèlement à la direction Y1. Ici, chaque patte d'encliquetage 118 coopèrent respectivement avec une encoche 121, ménagée par exemple dans le coin de l'une des extrémités 14 du barreau 3, à la fois pour l'encliquetage et le positionnement parallèlement à la direction Y1. Il n'est pas nécessaire de prévoir les renfoncements 21. Chaque bras 5 comporte deux pattes 118, portées à des extrémités longitudinales de la base 20 et s'étendant chacun dans la direction Z1. Chaque barreau 3 comporte deux encoches 121 correspondant à ces deux pattes 118. Chaque encoche présente une face parallèle aux directions Z1 et X1, venant en appui contre la patte 118 pour assurer le positionnement parallèlement à la direction Y1. Chaque encoche 121 présente une face parallèle aux directions X1 et Y1, qui permet une capture du barreau 3 entre un crochet formé à l'extrémité de la patte 118 et la base 20, parallèlement à la direction Z1, pour obtenir l'encliquetage du barreau 3.

Dans ce mode de réalisation, le pion 16 et l'encoche 19 ne sont pas nécessaires.

Pour renforcer le positionnement du barreau 3, le bras de fixation 5 comprend avantageusement une lame de stabilisation 116 qui est attachée à la base 20 en en faisant saillie selon la direction Z1. La lame 116 est disposée entre les deux pattes 118, de sorte à venir en contact avec la partie centrale 15 du barreau 3. La partie centrale 15 du barreau est ainsi enfilée entre la lame 116 et l'arceau 11 du bras 5, de sorte à être capturé parallèlement à la direction X1. De préférence, on prévoit que la partie centrale 15 du barreau 3 est pincée entre l'arceau 11 et la lame 116. La lame 116 reprend une partie des efforts appliqués sur le barreau 3 parallèlement à cette direction, ce qui réduit le risque de casse des pattes 118.

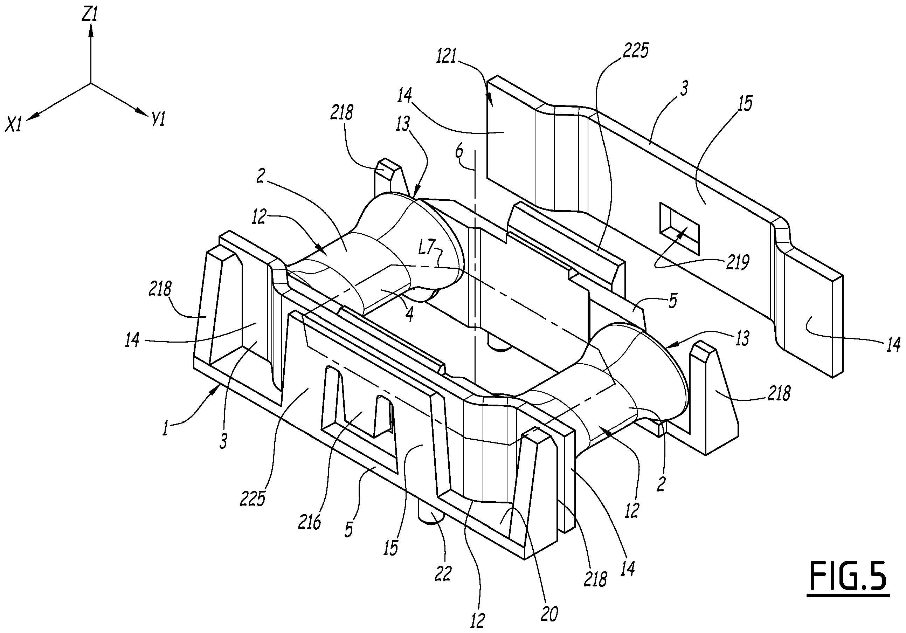

Le composant électrique du mode de réalisation illustré sur la figure 5, ainsi que son procédé de fabrication, sont identiques à ceux du mode de réalisation des figures 1 à 3, hormis pour les différences mentionnées ci-dessous. En particulier, le composant électrique de la figure 5 comprend une armature 1, deux enroulements 2, portés respectivement par deux bras de support 4 de l'armature 1, et deux barreaux 3, portés par deux bras de fixation de l'armature 1. Les mêmes signes de référence sont utilisés pour des éléments semblables entre le mode de réalisation des figures 1 à 3 et le mode de réalisation de la figure 5.

A la différence du mode de réalisation des figures 1 à 3, le mode de réalisation de la figure 5 prévoit que chaque bras 5 comprend des pattes de maintien 218, au lieu des pattes d'encliquetage 18. Chaque bras 5 comprend par exemple deux pattes de maintien 218, qui font saillie de la base 20 dans selon la direction Z1, aux extrémités longitudinales de la base 20. Chaque extrémité 14 du barreau 3 est positionnée, parallèlement à la direction X1, entre l'une des pattes 218 et la surface axiale 13 du bras de support 4, en étant enfilée, de préférence sans encliquetage, entre la patte 218 et la surface axiale 13. Il n'est donc pas nécessaire de prévoir les renfoncements 21 ou les encoches 121.

Dans ce mode de réalisation de la figure 5, le barreau 3 est dénué de l'encoche 19 et le bras 5 est dénué du pion 16. A la place, le bras 5 comprend avantageusement une patte d'encliquetage 216, qui coopère avec une ouverture d'encliquetage 219 qui traverse la partie centrale 15 du barreau 3. La patte d'encliquetage 216 est avantageusement disposée entre les pattes 218. Pour avoir une bonne résistance mécanique, la patte d'encliquetage 216 est par exemple rattachée à la base 20 par l'intermédiaire d'un portique 225, mais pourrait alternativement faire saillie directement de la base 20 de façon similaire aux pattes 18 des figures 1 et 2. Le portique 225, qui est agencé entre les pattes 218, assure aussi un fonction similaire à celle des pattes 218, puisque la partie centrale 15 est enfilée entre le portique 225 et l'arceau 11, ce qui positionne le barreau 3 parallèlement à la direction X1. La combinaison des pattes 218, du portique 225 et de la forme arquée du barreau 3, complémentaire à la forme de l'arceau 11, assure le positionnement du barreau parallèlement à la direction Y1. La patte d'encliquetage 216 du bras 5 est reçue dans l'ouverture 219 du barreau 3, ce qui fixe le barreau 3 sur le bras 5 par encliquetage.

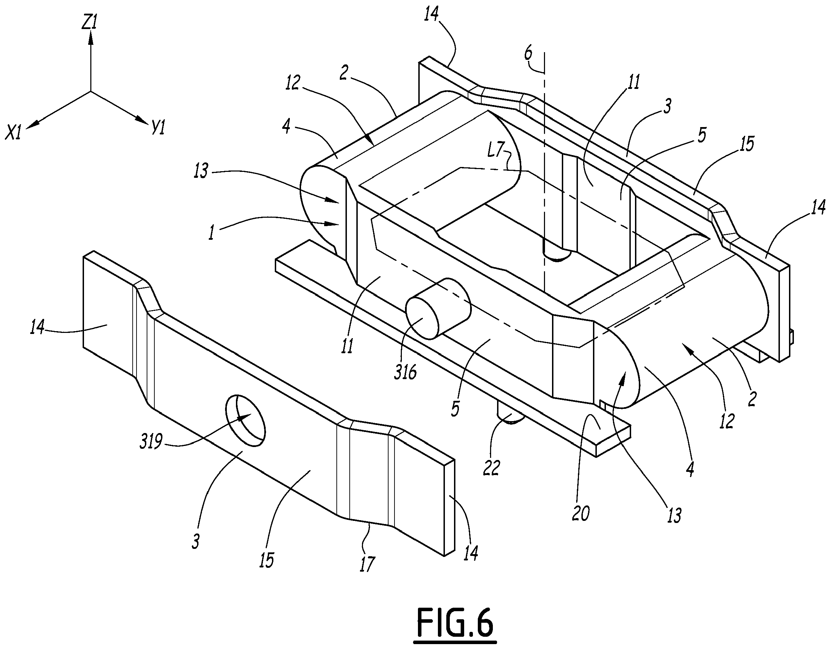

Le composant électrique du mode de réalisation illustré sur la figure 6, ainsi que son procédé de fabrication, sont identiques à ceux du mode de réalisation des figures 1 à 3, hormis pour les différences mentionnées ci-dessous. En particulier, le composant électrique de la figure 6 comprend une armature 1, deux enroulements 2, portés respectivement par deux bras de support 4 de l'armature 1, et deux barreaux 3, portés par deux bras de fixation de l'armature 1. Les mêmes signes de référence sont utilisés pour des éléments semblables entre le mode de réalisation des figures 1 à 3 et le mode de réalisation de la figure 6.

Contrairement au mode de réalisation des figures 1 à 3, le mode de réalisation de la figure 6 ne prévoit aucun encliquetage des barreaux 3, mais, à la place, prévoit une fixation des barreaux par bouterollage, comme expliqué ci-dessous. Il en résulte une conception simplifiée pour les barreaux 3 et les bras 5. En revanche, le matériau de l'armature 1 doit être compatible avec le bouterollage, à savoir doit être refusible. Il convient par exemple de prévoir que la matière plastique polymère de l'armature 1, ou pour le moins des bras 5, est thermoplastique.

Comme illustré sur la figure 6, le barreau 3 est dénué des renfoncements 21 et des encoches 19. Le barreau 3 est pourvu, de préférence au travers de sa partie centrale 15, d'un orifice de bouterollage 319, traversant le barreau 3 parallèlement à la direction X1.

Comme illustré sur la figure 6, le bras 5 est dénué des pattes 18 et du pion 16. Le bras 5 est pourvu, de préférence en saillie de l'arceau 11 parallèlement à la direction X1, un pion de bouterollage 316, complémentaire avec l'orifice 319. Outre le positionnement du barreau 3 effectué à l'aide de la base 20 et de l'arceau 11, le barreau 3 est positionné sur le pion de bouterollage 316 par l'intermédiaire de l'orifice de bouterollage 319, parallèlement à la direction X1.

Pour assembler le barreau 3 sur l'armature 1 pour le mode de réalisation de la figure 6, on enfile le barreau 3 sur le pion 316, le pion 316 étant reçu dans l'orifice 319 du barreau 3, tout en positionnant le barreau 3 sur le bras 5 de l'armature 1, par exemple avec guidage du bord 17 du barreau par la base 20 et mise en appui du barreau 3 contre l'arceau 11.

Ensuite, on fixe le barreau 3 ainsi positionné sur le bras de fixation 5 par bouterollage, ce qui implique de chauffer le pion 316, entrainant une fusion localisée du matériau de l'armature, de sorte à former un col à l'extrémité du pion 316. Une fois le pion 316 à solidifié avec son col, le barreau 3 se trouve capturé parallèlement à la direction X1 entre ledit col et l'arceau 11. Le barreau 3 est alors fixé de façon définitive à l'armature 1.

Cette méthode de fixation du barreau 3 présente l'avantage que la liaison entre le barreau 3 et l'armature 1 est très résistante et irréversible, et que le barreau 3 peut présenter les mêmes symétries que pour le mode de réalisation des figures 1 à 3, de sorte à pouvoir être monté indifféremment d'un côté ou de l'autre de l'armature 1 lors de la fabrication du composant.

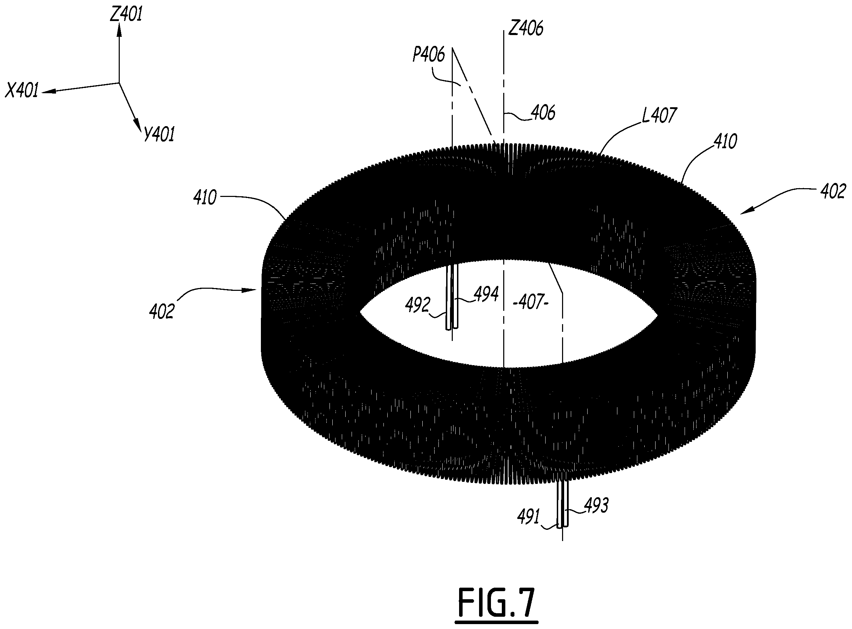

Le procédé de fabrication décrit pour les modes de réalisation des figures 1 à 6 peut s'appliquer au composant électrique du mode de réalisation de la figure 7. Ce composant électrique comprend deux enroulements 402 et une armature (non représentée).

On utilise un repère de référence incluant une direction longitudinale X401, une direction transversale Y401 et une direction de hauteur Z401, perpendiculaires entre elles et fixes par rapport à l'armature du composant électrique de la figure 7.

Le composant de la figure 7 constitue préférentiellement un capteur de courant. L'intensité du courant d'un conducteur 406 peut être déterminé grâce au composant électrique, lorsque le conducteur traverse une trajectoire directrice L407 décrite par le composant, en forme de boucle fermée, qui est ici circulaire en étant centrée sur un axe Z406 parallèle à la direction Z401. En pratique, l'armature du composant délimite une ouverture 407 du composant, dans le même plan, parallèle aux directions X401 et Y401, que la trajectoire directrice L407 et étant entourée par la trajectoire directrice L407, au travers de laquelle le conducteur 406 peut être passé. De préférence, ce composant est de type capteur de Rogowski et la tension induite reflète la valeur de la variation du courant traversant l'ouverture 407.

Ce composant est destiné à être connecté à une électronique de capteur, incluant une électronique de conditionnement se présentant par exemple sous la forme d'un circuit intégrateur.

L'armature constitue une unique pièce monolithique de forme annulaire, en formant une couronne circulaire autour de l'axe Z406, suivant la trajectoire L407, entièrement dans le même matériau que celui de l'armature 1 décrite ci-avant.

Le composant a une structure symétrique par rapport à un plan P406 comprenant l'axe Z406 et parallèle à la direction Y401.

L'armature comprend deux bras de support. L'armature est dénuée de bras de fixation, le composant ne comprenant aucun barreau.

Pour le mode de réalisation de la figure 7, un premier bras de support constitue une première partie, ici la moitié, de l'armature, en s'étendant selon la trajectoire L407 d'un premier côté du plan P406. L'autre bras de support s'étend de l'autre côté du plan P406 de façon symétrique. Chaque bras de support présente donc une forme de portion de couronne. Ici, chaque bras de support présente une section carrée, mais on pourrait prévoir toute forme de section souhaitée. Les bras de support sont rattachés l'un à l'autre par leurs deux extrémités pour que l'armature soit en forme de boucle fermée autour de l'axe Z406.

Chaque bras de support reçoit l'un des enroulements 402, formés directement en surface de leur bras de support respectif par une piste conductrice 410 respective. Le composant comporte donc deux pistes 410 distinctes, formant chacune un enroulement 402 séparé de l'autre enroulement 402. Chaque piste conductrice 410 est obtenue par le même procédé que les pistes conductrices 10 des composants des figures 1 à 6. En particulier, pour chaque enroulement 402, on effectue une gravure au laser d'une piste d'amorce sur le bras de support concerné, pour dessiner le tracé de la future piste conductrice 410. On effectue ensuite une métallisation de l'armature, pour former les deux pistes conductrices seulement à l'emplacement des deux pistes d'amorce gravées sur les bras de supports.

Chaque piste conductrice 410 s'enroule en spirale autour de son bras de support respectif, afin de former une succession de spires constituant l'enroulement 402 concerné. Les spires sont réparties successivement le long de la trajectoire L407, préférentiellement de façon régulière. Chaque spire entoure une portion de la trajectoire L407, de sorte que chaque enroulement 402 s'étend sur toute la portion de la trajectoire s'étendant d'un même côté du plan P406. Chaque piste 410 étant formée directement en surface de son bras de support respectif, c'est le contour de la section transversale du bras de support, ici de forme carrée, qui détermine la géométrie de la section transversale de chaque spire et donc l'enveloppe de l'enroulement 402.

Dans le présent exemple, les deux enroulements 402 ont leurs spires orientées en sens opposé. L'un des enroulements 402 a par exemple ses spires dans le sens direct le long de la trajectoire L407, alors que l'autre enroulement a ses spires en sens indirect. De préférence, chaque bras de support forme un noyau amagnétique pour son enroulement 402.

Le composant comporte aussi des moyens de connexion électrique des enroulements 402. Le premier enroulement 402 présente une borne 491 et une borne 492, positionnées aux extrémités de l'enroulement 402, au niveau du plan P406. Le deuxième enroulement 402 présente une borne 493 et une borne 494, au niveau du plan P406. Ces différentes bornes 491 à 494 sont préférentiellement destinées à être connectées et routées par l'intermédiaire de pistes d'une carte de circuit imprimé sur lequel le composant est conçu pour être positionné.

Par exemple, on prévoit que la borne 491 constitue une première borne du composant destinée à être connectée à un circuit de traitement du signal. La borne 492 est connectée à une première piste de retour formée sur la carte de circuit imprimé, la première piste de retour s'étendant sous l'enroulement 402 portant la borne 492 en suivant la trajectoire directrice L407, en sens inverse de l'enroulement, jusqu'à atteindre la borne 493, de sorte que la première boucle de retour relie le premier enroulement 402 au deuxième enroulement 402 en série. La borne 494 est connectée à une deuxième piste de retour, formée sur la carte de circuit imprimé, la deuxième piste de retour s'étendant sous l'enroulement 402 portant la borne 494, de façon symétrique à la première piste de retour par rapport au plan P406 en suivant la trajectoire directrice L407, en sens inverse de l'enroulement 402. L'extrémité opposée de cette deuxième piste de retour constitue la deuxième borne du composant. En série, se succèdent donc le premier enroulement 402, la première piste de retour, le deuxième enroulement 102 et la deuxième piste de retour.

Pour fabriquer le composant de la figure 7, on met en oeuvre un procédé de fabrication comprenant une fourniture ou une fabrication, de préférence par moulage, de l'armature, puis une gravure par laser des bras de support de l'armature pour former les pistes d'amorce selon le tracé des futurs enroulements 402, puis enfin des traitements chimiques, incluant une métallisation des pistes d'amorce pour faire croître les pistes conductrices 410 formant les enroulements 402. En particulier, comme pour le cas illustré sur la figure 3, vignettes B et C, la gravure par laser de l'armature du mode de réalisation de la figure 7 peut être effectuée en deux fois en retournant le composant.

Toute caractéristique décrite dans ce qui précède pour un mode de réalisation ou une variante peut être mise en oeuvre pour les autres modes de réalisation et variantes décrits dans ce qui précède.

## Revendications

1. Procédé de fabrication d'un composant électrique, constituant préférentiellement un capteur de courant, **caractérisé en ce que** le composant électrique comprend :
• une armature (1), qui est formée par un matériau comprenant une matière plastique polymère et un additif organométallique, l'armature (1) comprenant un bras de support (4) qui s'étend le long d'une trajectoire directrice (L7 ; L407) ; et
• un enroulement (2 ; 402), qui est formé directement en surface du bras de support (4) par une piste conductrice (10 ; 410) décrivant des spires de l'enroulement (2 ; 402), qui sont réparties le long de la trajectoire directrice (L7 ; L407) et qui entourent la trajectoire directrice (L7 ; L407) ;
et **en ce que** le procédé de fabrication comprend successivement :
• une fourniture ou une fabrication de l'armature (1) ;
• une gravure par laser du bras de support (4), pour graver une piste d'amorce (50) décrivant les spires de l'enroulement (2 ; 402) et où l'additif organométallique est localement activé ; et
• une métallisation de la piste d'amorce (50) avec un métal conducteur pour former la piste conductrice (10 ; 410) directement en surface du bras de support (4), selon les spires décrites par la piste d'amorce (50).

2. Procédé de fabrication selon la revendication 1, dans lequel :
• le bras de support (4) comprend un premier côté (52) et un deuxième côté (53) opposés et jointifs de part et d'autre de la trajectoire directrice (L7 ; L407) ; et
• la gravure par laser comprend :
◆ une gravure par laser d'une première partie (54) de la piste d'amorce (50) sur le premier côté (52), la première partie (54) de la piste d'amorce (50) décrivant, pour chaque spire, une première portion seulement de ladite spire, et
◆ une gravure par laser d'une deuxième partie de la piste d'amorce (50) sur le deuxième côté (53), seulement après la gravure de la première partie (54) de la piste d'amorce (50), la deuxième partie (55) de la piste d'amorce (50) décrivant, pour chaque spire, une deuxième portion de la spire complétant la première portion de ladite spire.

3. Procédé de fabrication selon la revendication 2, dans lequel la gravure par laser comprend :
• un positionnement l'armature (1) pour que le premier côté (52) soit tourné face à un graveur laser (51), pour que la gravure par laser de la première partie (54) de la piste d'amorce (50) soit effectuée par le graveur laser ; et
• un repositionnement l'armature (1) pour que le deuxième côté (53) soit tourné face au graveur laser (51), pour que la gravure par laser de la deuxième partie (55) de la piste d'amorce (50) soit effectuée par le graveur laser (51).

4. Procédé de fabrication selon l'une quelconque des revendications précédentes, dans lequel la fabrication de l'armature (1) comprend un moulage de l'armature (1) par injection du matériau dans un moule.

5. Procédé de fabrication selon la revendication 4, dans lequel :
• le moule comprend :
◆ une chambre de conformation (31, 32) du bras de support (4) ;
◆ une première ouverture (35) pour l'injection d'une première partie (37) du matériau ;
◆ une deuxième ouverture (36) pour l'injection d'une deuxième partie (38) du matériau ; et
◆ une chambre de rencontre (34, 33) dans laquelle débouche la deuxième ouverture (36) et qui communique avec la première ouverture (35) par l'intermédiaire de la chambre de conformation (31, 32) du bras de support (4) ; et
• le moulage par injection comprend :
◆ une injection de la première partie (37) du matériau dans le moule par la première ouverture (35), de sorte que la première partie (37) du matériau :
◊ envahisse la chambre de conformation du bras de support (4), le bras de support (4) étant alors entièrement formé par la première partie (37) du matériau ;
◊ s'étende jusque dans la chambre de rencontre (34, 33) ;
◆ une injection de la deuxième partie (38) du matériau dans le moule par la deuxième ouverture (36), de sorte que la deuxième partie (38) du matériau rencontre la première partie (37) du matériau dans la chambre de rencontre (34, 33), l'armature (1) étant formée par combinaison de la première partie (37) du matériau et de la deuxième partie (38) du matériau.

6. Procédé de fabrication selon la revendication 5, dans lequel la première ouverture (35) et la deuxième ouverture (36) sont disposées dans un même plan et dans une même orientation, de sorte que :
• la première ouverture (35) conforme un premier plot (22) de l'armature (1), par l'injection de la première partie (37) du matériau ; et
• la deuxième ouverture (36) conforme un deuxième plot (22) de l'armature (1), par l'injection de la deuxième partie (38) du matériau, le premier plot (22) et le deuxième plot (22) étant configurés pour réaliser un positionnement du composant électrique sur une carte de circuit imprimé.

7. Procédé de fabrication selon l'une quelconque des revendications 4 à 6, dans lequel :
• le procédé de fabrication comprend :
◆ une fabrication ou une fourniture d'un barreau (3) en matériau ferromagnétique, et
◆ une fixation du barreau (3) sur un bras de fixation (5) appartenant à l'armature (1), après la fourniture ou la fabrication de l'armature (1) ; et
• le moulage comprend la formation du bras de support (4) et du bras de fixation (5) dans le moule, de sorte que le bras de support (4) et le bras de fixation (5) sont formés d'un seul tenant.

8. Procédé de fabrication selon la revendication 7, dans lequel la fixation du barreau (3) comprend un encliquetage du barreau sur le bras de fixation (5), à l'aide de moyens d'encliquetage complémentaires (18, 21 ; 118, 121 ; 216, 219) appartenant au barreau (3) et au bras de fixation (5).

9. Procédé de fabrication selon l'une quelconque des revendications 7 ou 8, dans lequel la fixation du barreau (3) comprend :
• un positionnement du barreau (3) sur le bras de fixation (5), avec enfilement d'un orifice de bouterollage (319), traversant du barreau (3), sur un pion de bouterollage (316), appartenant au bras de fixation (5) ; et
• une fixation du barreau (3) ainsi positionné sur le bras de fixation (5) par bouterollage, en effectuant une fusion du pion de bouterollage (316).

10. Composant électrique, **caractérisé en ce que** le composant électrique est susceptible d'être obtenu à l'aide du procédé de fabrication selon l'une quelconque des revendications précédentes, et **en ce que** le composant électrique comprend :
• une armature (1), qui est formée par un matériau comprenant une matière plastique polymère et un additif organométallique, l'armature (1) comprenant un bras de support (4) qui s'étend le long d'une trajectoire directrice (L7 ; L407) ; et
• un enroulement (2 ; 402), qui est formé directement en surface du bras de support (4) par une piste conductrice (10 ; 410) décrivant des spires de l'enroulement (2 ; 402), qui sont réparties le long de la trajectoire directrice (L7 ; L407) et qui entourent la trajectoire directrice (L7 ; L407).

## Patentansprüche

1. Verfahren zur Herstellung eines elektrischen Bauteils, das vorzugsweise einen Stromsensor bildet, **dadurch gekennzeichnet, dass** das elektrische Bauteil umfasst:
• einen Rahmen (1), der aus einem Material gebildet wird, das aus einem polymeren Kunststoff und einem metallorganischen Additiv besteht, wobei der Rahmen (1) einen Tragarm (4) umfasst, der sich entlang einer Leitbahn (L7; L407) erstreckt; und
• eine Wicklung (2; 402), die direkt auf der Oberfläche des Tragarms (4) durch eine Leiterspur (10; 410) gebildet wird, die Windungen der Wicklung (2; 402) beschreibt, die entlang der Leitbahn (L7; L407) verteilt sind und die Leitbahn (L7; L407) umschließen;
und dass das Herstellungsverfahren nacheinander umfasst:
• Bereitstellung oder Herstellung des Rahmens (1);
• Lasergravieren des Tragarms (4), um eine Primerspur (50) zu ätzen, die die Windungen der Wicklung (2; 402) beschreibt und in der das metallorganische Additiv lokal aktiviert ist; und
• eine Metallisierung der Primerspur (50) mit einem leitenden Metall, um die Leiterspur (10; 410) direkt auf der Oberfläche des Tragarms (4) entsprechend den von der Primerspur (50) beschriebenen Windungen zu bilden.

2. Herstellungsverfahren nach Anspruch 1, wobei:
• der Tragarm (4) eine erste Seite (52) und eine zweite Seite (53) umfasst, die einander gegenüberliegen und auf beiden Seiten der Leitbahn (L7; L407) aneinanderstoßen; und
• das Lasergravieren umfasst:
◆ Lasergravieren eines ersten Teils (54) der Vorlaufspur (50) auf der ersten Seite (52), wobei der erste Teil (54) der Primerspur (50) für jede Windung nur einen ersten Abschnitt der Windung beschreibt, und
◆ Lasergravieren eines zweiten Teils der Primerspur (50) auf der zweiten Seite (53), erst nach dem Gravieren des ersten Teils (54) der Primerspur (50), wobei der zweite Teil (55) der Primerspur (50) für jede Windung einen zweiten Abschnitt der Windung beschreibt, der den ersten Abschnitt der Windung ergänzt.

3. Herstellungsverfahren nach Anspruch 2, wobei das Lasergravieren umfasst:
• eine Positionierung des Rahmens (1), damit die erste Seite (52) einem Lasergravierer (51) zugewandt ist, damit das Lasergravieren des ersten Abschnitts (54) der Primerspur (50) durch den Lasergravierer erfolgt; und
• eine Neupositionierung des Rahmens (1), damit die zweite Seite (53) dem Lasergravierer (51) zugewandt ist, damit das Lasergravieren des zweiten Abschnitts (55) der Primerspur (50) durch den Lasergravierer (51) erfolgt.

4. Herstellungsverfahren nach einem der vorhergehenden Ansprüche, wobei die Herstellung des Rahmens (1) ein Gießen des Rahmens (1) durch Einspritzen des Materials in eine Form umfasst.

5. Herstellungsverfahren nach Anspruch 4, wobei:
• die Form umfasst:
◆ eine Formungskammer (31, 32) des Tragarms (4);
◆ eine erste Öffnung (35) zum Einspritzen eines ersten Teils (37) des Materials;
◆ eine zweite Öffnung (36) zum Einspritzen eines zweiten Teils (38) des Materials; und
◆ eine Begegnungskammer (34, 33), in die die zweite Öffnung (36) mündet und die über die Formungskammer (31, 32) des Tragarms (4) mit der ersten Öffnung (35) in Verbindung steht; und
• das Spritzgießen umfasst:
◆ ein Einspritzen des ersten Teils (37) des Materials in die Form durch die erste Öffnung (35), so dass der erste Teil (37) des Materials:
◊ in die Formungskammer des Tragarms (4) eindringt, wobei der Tragarm (4) dann vollständig durch den ersten Teil (37) des Materials gebildet wird;
◊ sich bis in die Begegnungskammer (34, 33) erstreckt;
◆ Einspritzen des zweiten Teils (38) des Materials in die Form durch die zweite Öffnung (36), so dass der zweite Teil (38) des Materials in der Begegnungskammer (34, 33) auf den ersten Teil (37) des Materials trifft, wobei der Rahmen (1) durch Kombination des ersten Teils (37) des Materials und des zweiten Teils (38) des Materials gebildet wird.

6. Herstellungsverfahren nach Anspruch 5, bei dem die erste Öffnung (35) und die zweite Öffnung (36) in derselben Ebene und in derselben Ausrichtung angeordnet sind, so dass:
• die erste Öffnung (35) eine erste Anschlussfläche (22) des Rahmens (1) durch Einspritzen des ersten Teils (37) des Materials formt; und
• die zweite Öffnung (36) eine zweite Anschlussfläche (22) des Rahmens (1) durch Einspritzen des zweiten Teils (38) des Materials formt, wobei die erste Anschlussfläche (22) und die zweite Anschlussfläche (22) so konfiguriert sind, dass sie eine Positionierung des elektrischen Bauteils auf einer Leiterplatte bewirken.

7. Herstellungsverfahren nach einem der Ansprüche 4 bis 6, wobei:
• das Herstellungsverfahren umfasst:
◆ eine Herstellung oder Lieferung eines Stabs (3) aus ferromagnetischem Material und
◆ ein Befestigen des Stabs (3) an einem zum Rahmen (1) gehörenden Befestigungsarm (5), nachdem der Rahmen (1) geliefert oder hergestellt wurde; und
• das Gießen das Formen des Tragarms (4) und des Befestigungsarms (5) in der Form umfasst, so dass der Tragarm (4) und der Befestigungsarm (5) in einem Stück geformt werden.

8. Herstellungsverfahren nach Anspruch 7, wobei das Befestigen des Stabs (3) ein Einrasten des Stabs am Befestigungsarm (5) mit Hilfe von komplementären Einrastmitteln (18, 21; 118, 121; 216, 219) umfasst, die zum Stab (3) und zum Befestigungsarm (5) gehören.

9. Herstellungsverfahren nach einem der Ansprüche 7 oder 8, wobei das Befestigen des Stabs (3) Folgendes umfasst:
• Positionieren des Stabs (3) auf dem Befestigungsarm (5), wobei ein durch den Stab (3) verlaufendes Bolzenloch (319) auf einen Bolzenstift (316) des Befestigungsarms (5) geschoben wird; und
• Befestigung des so positionierten Stabs (3) an dem Befestigungsarm (5) durch Aufweiten, indem ein Schmelzen des Bolzenstifts (316) durchgeführt wird.

10. Elektrisches Bauteil, **dadurch gekennzeichnet, dass** man das elektrische Bauteil mithilfe des Herstellungsverfahrens nach einem der vorhergehenden Ansprüche erhalten kann, und dass das elektrische Bauteil Folgendes umfasst:
• einen Rahmen (1), der aus einem Material gebildet wird, das aus einem polymeren Kunststoff und einem metallorganischen Additiv besteht, wobei der Rahmen (1) einen Tragarm (4) umfasst, der sich entlang einer Leitbahn (L7; L407) erstreckt; und
• eine Wicklung (2; 402), die direkt auf der Oberfläche des Tragarms (4) durch eine Leiterspur (10; 410) gebildet wird, die Windungen der Wicklung (2; 402) beschreibt, die entlang der Leitbahn (L7; L407) verteilt sind und die Leitbahn (L7; L407) umschließen.

## Claims

1. A method for manufacturing an electrical component, preferentially forming a current sensor, **characterized in that** the electrical component comprises:
• an armature (1), which consists of a material comprising a polymeric plastic material and an organometallic additive, the armature (1) comprising a support arm (4) which extends along a guiding trajectory (L7; L407); and
• a winding (2; 402), which is formed directly on the surface of the support arm (4) by a conductor track (10; 410) forming turns of the winding (2; 402), which are distributed along the guiding trajectory (L7; L407) and which encircle the guiding trajectory (L7; L407);
and **in that** the manufacturing process comprises successively:
• providing or manufacturing the armature (1);
• laser engraving of the support arm (4), for engraving an initiator track (50) forming the turns of the winding (2; 402) and where the organometallic additive is locally activated; and
• metallizing the initiator track (50) with a conducting metal so as to form the conductor track (10; 410) directly onto the surface of the support arm (4), according to the turns formed by the initiator track (50).

2. The manufacturing method according to claim 1, wherein:
• the support arm (4) comprises a first side (52) and a second side (53) which are opposite and contiguous on either side of the guiding trajectory (L7; L407); and
• the laser engraving comprises:
◆ laser engraving of a first part (54) of the initiator track (50) on the first side (52), the first part (54) of the initiator track (50) forming, for each turn, only a first portion of the initiator track, and
◆ laser engraving of a second part of the initiator track (50) on the second side (53), only after the engraving of the first part (54) of the initiator track (50), the second part (55) of the initiator track (50) forming, for each turn, a second portion of the turn completing the first portion of said turn.

3. The manufacturing method according to claim 2, wherein the laser engraving comprises:
• positioning of the armature (1) so that the first side (52) is oriented facing a laser engraver (51), so that the laser engraving of the first part (54) of the initiator track (50) is performed by the laser engraver; and
• repositioning of the armature (1) so that the second side (53) is oriented facing the laser engraver (51), so that the laser engraving of the second part (55) of the initiator track (50) is carried out by the laser engraver (51).

4. The manufacturing method according to any of the preceding claims, wherein the manufacturing of the armature (1) comprises molding of the armature (1) by injecting the material into a mold.

5. The manufacturing method according to claim 4, wherein:
• the mold comprises:
◆ a shaping chamber (31, 32), for shaping the support arm (4);
◆ a first opening (35), for injecting a first part (37) of the material;
◆ a second opening (36), for injecting a second part (38) of the material; and
◆ a joining chamber (34, 33), into which the second opening (36) exits and which communicates with the first opening (35) via the shaping chamber (31, 32) of the support arm (4); and
• the injection molding comprises:
◆ injecting the first part (37) of the material into the mold through the first opening (35) such that the first part (37) of the material:
◊ incurs into the shaping chamber of the support arm (4), the support arm (4) then being entirely formed by the first part (37) of the material;
◊ extends into the joining chamber (34, 33);
◆ injecting the second part (38) of the material into the mold through the second opening (36) in such a way that the second part (38) of the material meets the first part (37) of the material in the joining chamber (34, 33), the armature (1) being formed by combining the first part (37) of the material and the second part (38) of the material.

6. The manufacturing method according to claim 5, wherein the first opening (35) and the second opening (36) are arranged in a same plane and along a same orientation, so that:
• the first opening (35) shapes a first stud (22) of the armature (1), by injecting the first part (37) of the material; and
• the second opening (36) shapes a second stud (22) of the armature (1), by injecting the second part (38) of the material, the first stud (22) and the second stud (22) being configured for achieve a positioning of the electrical component on a printed circuit board.

7. The manufacturing method according to any of claims 4 to 6, wherein:
• the manufacturing method comprises:
◆ manufacturing or providing a bar (3) of ferromagnetic material, and
◆ attaching the bar (3) on an attachment arm (5) belonging to the armature (1), after the supply or the manufacture of the armature (1); and
• the molding comprises forming the support arm (4) and the attachment arm (5) in the mold so that the support arm (4) and the attachment arm (5) are formed monolithically.

8. The manufacturing method according to claim 7, wherein the attaching of the bar (3) comprises snap-fitting the bar on the attachment arm (5), using matching snap-fitting means (18, 21; 118, 121; 216, 219) belonging to the bar (3) and to the attachment arm (5).

9. The manufacturing method according to any of claims 7 or 8, wherein the attaching of the bar (3) comprises:
• positioning of the bar (3) onto the attachment arm (5), with slipping on a snap-riveting hole (319) crossing through the bar (3), along a snap-riveting pin (316) belonging to the attachment arm (5); and
• attaching of the bar (3) thus positioned onto the attachment arm (5) by snap-riveting, by carrying out a melting of the snap-riveting pin (316).

10. An electrical component, **characterized in that** the electrical component is likely to be produced by the manufacturing method according to any of preceding claims, and **in that** the electrical component comprises:
• an armature (1), which consists of a material comprising a polymeric plastic material and an organometallic additive, the armature (1) comprising a support arm (4) which extends along a guiding trajectory (L7; L407); and
• a winding (2; 402) which is formed directly on the surface of the support arm (4) by a conductor track (10; 410) forming turns of the winding (2; 402), which are distributed along the guiding trajectory (L7; L407) and which surround the guiding trajectory (L7; L407).
